# EUROPÄISCHE PATENTANMELDUNG

(11) **EP 1 120 708 A2**
(43) Veröffentlichungstag der Anmeldung: **01.08.2001**
(21) Anmeldenummer: 00125833.4
(22) Anmeldetag: 25.11.2000
(51) Int. Cl.: G06F 9/38

(54) **Anordnung und Verfahren zur Signalverarbeitung und Speicherung**

(30) Priorität: 25.01.2000 DE 10003006
(71) Anmelder: ROBERT BOSCH GMBH, 70442 Stuttgart (DE)
(72) Erfinder: Aue, Axel, 70825 Korntal-Muenchingen (DE); Martin, Dirk, 70794 Filderstadt (DE)

(57) **Zusammenfassung**

Die Erfindung betrifft Verfahren zur Speicherung und Signalverarbeitung/Filterung sowie eine Speicheranordnung, eine Signalverarbeitungsanordnung und insbesondere eine digitale Filteranordnung mit mehreren Filterstufen zur digitalen Verarbeitung/Filterung von Eingangswerten (6), mit einem Speicherbereich (9) und einer Signalverarbeitungstufe, die insbesondere mindestens eine Multiplizierer-Akkumulator-Stufe (MAC) (10)enthält, die mindestens einen Multiplizierer (12) und mindestens einen Summierer (13) aufweist. Die Eingangswerte (6), Koeffizienten (11) und Ausgangswerte (7) der Anordnung sind in dem Speicherbereich (9) ablegbar und aus diesem bei Bedarf wieder aufrufbar. Die Eingangswerte werden mit den Koeffizienten zu Ausgangswerten verknüpft. Um einen übergeordneten Mikroprozessor (1) durch die digitale Verarbeitung/Filterung der Eingangswerte (6) nicht zu belasten, wird vorgeschlagen, dass die digitale Filteranordnung einen Direct-Memory-Access (DMA)-Controller (17) zur Koordinierung der Datenübertragung der Filterkoeffizienten (11), der Eingangswerte (6) und der Ausgangswerte (7) zwischen der Multiplizierer-Akkumulator-Stufe (MAC) (10) und dem Speicherbereich (9) aufweist.

## Beschreibung

### Stand der Technik

Die vorliegende Erfindung betrifft eine digitale Speicheranordnung sowie Signalverarbeitungsanordnung, insbesondere eine Filteranordnung, mit mehreren Filterstufen, zur digitalen Signalverarbeitung/Speicherung, insbesondere Filterung, von Eingangswerten bzw. Eingangssignalen. Die digitale Signalverarbeitungsanordnung umfaßt einen Speicherbereich und mindestens eine Multiplizierer-Akkumulator-Stufe (MAC), die mindestens einen Multiplizierer und mindestens einen Summierer aufweist. Die Eingangswerte, Koeffizienten, insbesondere feste Filterkoeffizienten und Ausgangswerte der Signalverarbeitungsanordnung sind in dem Speicherbereich ablegbar und aus diesem bei Bedarf wieder aufrufbar. Der Multiplizierer bildet Produkte ,insbesondere für alle Filterstufen Teilprodukte, aus den Eingangswerten und den Koeffizienten und der Summierer bildet Summen der Produkte, insbesondere der Teilprodukte aller Filterstufen, als Ausgangswerte bzw. Ausgangssignale der Signalverarbeitungsanordnung.

Die Erfindung betrifft außerdem ein Verfahren zur Speicherung von Werten sowie digitalen Signalverarbeitung, insbesondere Filterung, von Eingangswerten bzw.

Eingangssignalen in einer digitalen Filteranordnung. Dabei werden die Eingangswerte, Koeffizienten, insbesondere feste Filterkoeffizienten, und Ausgangswerte der Speicheranordnung bzw. Signalverarbeitungsanordnung in einem Speicherbereich abgelegt und bei Bedarf aus diesem wieder aufgerufen. In einer Multiplizierer-Akkumulator-Stufe (MAC) der Signalverarbeitungsanordnung werden Produkte, insbesondere für alle Filterstufen Teilprodukte, aus den Eingangswerten und den Koeffizienten und Summen der Produkte, insbesondere Teilprodukte aller Filterstufen, als Ausgangswerte bzw. Ausgangssignale der Signalverarbeitungsanordnung gebildet.

In neuerer Zeit geht man mehr und mehr dazu über, die Signalverarbeitung nicht analog sondern digital durchzuführen. Die Vorteile liegen in der höheren Genauigkeit und Reproduzierbarkeit sowie in der geringeren Störempfindlichkeit. Nachteilig ist der höhere Schaltungsaufwand, der jedoch angesichts des zunehmenden Integrationsgrades digitaler Schaltungen immer weniger ins Gewicht fällt.

Bei der digitalen Signalverarbeitung werden statt kontinuierlicher Signale diskrete Zahlenfolgen (abgetastete und quantisierte Signale) verarbeitet. In dem Maße, in dem digitale Signale digital verarbeitet werden, werden auch digitale Signalverarbeitungsanordnungen, z.B. Filteranordnungen, und entsprechende Speicheranordnungen immer mehr eingesetzt. Durch die digitale Filterung werden in dem Signal bestimmte Frequenzen ausgeblendet oder unterdrückt, um das Signal-/Rauschverhältnis zu verbessern.

Auch bei Steuergeräten für Kraftfahrzeuge ist es bspw. für einige Funktionen der Motorsteuerung erforderlich, die Eingangssignale bzw. die diskreten Eingangswerte zu filtern. Das Steuergerät wird zur Steuerung/Regelung bestimmter Funktionen in einem Kraftfahrzeug, bspw. der Brennkraftmaschine, des Getriebes, der Bremsen oder der Klimatisierung/Heizung, eingesetzt. Das Steuergerät weist einen Mikrocontroller mit einem Prozessor auf. Auf dem Prozessor wird ein Steuerprogramm ausgeführt, um die Funktion des Steuergeräts zu erfüllen. Im Rahmen der Ausführung des Steuerprogramms werden Eingangssignale verarbeitet und entsprechende Steuerungs-/Regelungsbefehle erzeugt.

Eine digitale Signalverarbeitung, insbesondere Filterung, von Eingangswerten ist relativ zeit- und rechenintensiv. Aus dem Stand der Technik ist es deshalb bekannt, eine digitale Signalverarbeitung, z.B. eine digitale Filterung, von Eingangswerten mit Hilfe eines digitalen Signalprozessors (DSP) auszuführen. Ein DSP kann bestimmte Funktionen selbstständig, d.h. ohne Unterstützung durch den Prozessor des Steuergeräts ausführen. Der Einsatz eines DSP zur digitalen Signalverarbeitung, speziell Filterung, der Eingangswerte hat den Vorteil, dass die digitale Signalverarbeitung bzw. Filterung ohne Beanspruchung des übergeordneten Prozessors des Steuergeräts erfolgt. Der Prozessor steht nach wie vor voll zur Erfüllung der Steuerungs-/Regelungsaufgaben zur Verfügung. Der Einsatz eines DSP zur digitalen Signalverarbeitung, insbesondere Filterung, der Eingangswerte hat den Nachteil, dass der DSP eine komplexe Struktur aufweist und damit verbunden seine Integration in einem Steuergerät kosten- und zeitintensiv ist.

Aus den vorgenannten Nachteilen des Standes der Technik ergibt sich die Aufgabe der vorliegenden Erfindung, eine digitale Signalverarbeitung, insbesondere Filterung, von Eingangswerten möglichst schnell und zuverlässig auszuführen, ohne durch die digitale Signalverarbeitung bzw. Filterung einen der Signalverarbeitungsanordnung, insbesondere dem digitalen Filter, übergeordneten Prozessor zur Signalverarbeitung zu belasten.

Zur Lösung dieser Aufgabe schlägt die Erfindung ausgehend von der digitalen Signalverarbeitungsanordnung, insbesondere einer Filteranordnung, der eingangs genannten Art vor, dass die digitale Signalverarbeitungsanordnung bzw. Filteranordnung einen Direct-Memory-Access (DMA)-Controller zur Koordinierung der Datenübertragung der Koeffizienten, insbesondere der Filterkoeffizienten, der Eingangswerte bzw. Eingangssignale und der Ausgangswerte bzw. Ausgangssignale zwischen der Multiplizierer-Akkumulator-Stufe (MAC) und dem Speicherbereich aufweist.

Im Weiteren wird insbesondere auf eine Filteranordnung eingegangen. Die weiteren Ausführungen, speziell das Ausführungsbeispiel sind aber ebenso allgemein auf eine Signalverarbeitungsanordnung bzw. eine Speicheranordnung mit Signalverarbeitungsstufe gemäss der unabhängigen Ansprüche zu beziehen, wie dies ebenfalls in der Einleitung angedeutet ist.

Der Aufbau und die Funktion von DMA-Controllern kann einer Vielzahl von Lehrbüchern und Fachzeitschriften entnommen werden. Diesbezüglich wird bspw. auf Tietze, Ullrich: Halbleiter-Schaltungstechnik/ U. Tietze, Ch. Schenk, 9. Aufl., Springer Verlag, 1989, S. 704 bis 707 verwiesen. Ein DMA-Controller weist einen oder mehrere DMA-Kanäle auf, über die die Datenübertragung aus einem Speicherbereich zu einem beliebigen Modul eines Mikroprozessors erfolgt. Im Gegensatz zur Datenübertragung über eine Schnittstelle, bei der zur Übertragung eines Bits mehrere Befehle durchlaufen werden müssen, die eine Vielzahl von Taktzyklen des Rechnerkerns (Central Processing Unit; CPU) des übergeordneten Mikroprozessors erfordern, muß bei der Datenübertragung mit Hilfe des DMA-Controllers die Datenübertragung durch den Rechnerkern lediglich angestoßen und die gefilterten Ausgangswerte nach der Filterung aus dem Speicherbereich ausgelesen werden. Die Datenübertragung der Filterkoeffizienten, der Eingangswerte und der Ausgangswerte wird von dem DMA-Controller derart koordiniert, dass die gesamte digitale Signalverarbeitung, insbesondere Filterung der Eingangswerte nahezu ohne Rechenzeitbelastung des Rechnerkerns des Mikroprozessors erfolgt.

Erfindungsgemäß wird also ein Mikroprozessor einer der Signalverarbeitunganordnung, insbesondere Filteranordnung, übergeordneten Signalverarbeitungseinrichtung (z. B. ein Kraftfahrzeug-Steuergerät) durch eine Multiplizierer-Akkumulator-Stufe (MAC) mit mindestens einem Multiplizierer und mindestens einem Summierer und einem Direct-Memory-Access (DMA)-Controller erweitert. Die MAC- und DMA-Controller-Erweiterung des Mikroprozessors ist besonders einfach aufgebaut und kann ohne großen Kosten- und Arbeitsaufwand in die übergeordnete Signalverarbeitungseinrichtung integriert werden.

Der Mikroprozessor ist bspw. Bestandteil eines Steuergeräts für ein Kraftfahrzeug, das zur Steuerung/Regelung bestimmter Funktionen in dem Kraftfahrzeug eingesetzt wird. Das Steuergerät verarbeitet im Rahmen der Steuerung/Regelung der Kraftfahrzeugfunktionen analoge und/oder digitale Signale. Für bestimmte Steuerungsfunktionen der Brennkraftmaschine müssen die Signale gefiltert werden. Dazu werden die analogen Eingangssignale in einem Analog-Digital-Umsetzer (ADU) in digitale Eingangswerte umgesetzt oder gleich die digitalen Eingangswerte herangezogen, falls sie vorliegen. Die digitalen Eingangswerte werden in dem Speicherbereich abgelegt und von dort über den oder die DMA-Kanäle in die MAC übertragen. In der MAC werden die gefilterten Ausgangswerte berechnet und über die DMA-Kanäle wieder in dem Speicherbereich abgelegt. Von dort werden sie von dem Mikroprozessor des Steuergeräts als gefilterte Signalwerte abgeholt.

Gemäß einer vorteilhaften Weiterbildung der vorliegenden Erfindung wird vorgeschlagen, dass die Filteranordnung einen Analog-Digital-Umsetzer (ADU) und einen Digital-Analog-Umsetzer (DAU) aufweist, wobei der DMA-Controller die Datenübertragung der Eingangswerte von dem ADU in den Speicherbereich und der Ausgangswerte von dem Speicherbereich zu dem DAU koordiniert. Gemäß dieser Weiterbildung verarbeitet der Mikroprozessor der übergeordneten Signalverarbeitungseinrichtung also analoge Signale, die vor einer digitalen Filterung digitalisiert werden müssen. Ebenso müssen die gefilterten Ausgangswerte nach der digitalen Filterung erst wieder in analoge Ausgangssignale umgewandelt werden, bevor sie von dem Mikroprozessor weiterverarbeitet werden können. Um den Rechnerkern des Mikroprozessors möglichst wenig mit der digitalen Filterung der Signale, insbesondere mit der Umwandlung zwischen Analog- und Digitalsignalen, zu belasten, wird auch die Datenübertragung zwischen dem ADU und dem Speicherbereich bzw. zwischen dem Speicherbereich und dem DAU ebenfalls von dem DMA-Controller koordiniert.

Gemäß einer bevorzugten Ausführungsform der vorliegenden Erfindung wird vorgeschlagen, dass die Filteranordnung Mittel zum Bilden des Betrags der Eingangswerte aufweist, wobei der DMA-Controller die Datenübertragung der Eingangswerte von dem Speicherbereich zu den Mitteln zum Bilden des Betrags und von den Mitteln zu der MAC koordiniert. Durch die Mittel zum Bilden des Betrags der Eingangswerte wird sichergestellt, dass die digitale Filterung nur mit positiven Eingangswerten durchgeführt wird.

Vorteilhafterweise sind die Mittel zum Bilden des Betrags der Eingangswerte einen digitalen Komparator aufweisen. In dem Komparator wird überprüft, ob ein Eingangswert größer oder kleiner Null ist. Falls der Eingangswert kleiner als Null ist, wird das Vorzeichen des Eingangswerts umgedreht.

Der Speicherbereich, in dem die Filterkoeffizienten, die Eingangswerte und die Ausgangswerte abgelegt werden, separat von dem Mikroprozessor ausgeführt, um den Rechnerkern (CPU) bei DMA-Aktivitäten nicht zu unterbrechen. Vorteilhafterweise ist der Speicherbereich als ein Schreib-Lese-Speicher mit wahlfreiem Zugriff (Random Access Memory, RAM) ausgebildet. In dem Speicherbereich sind auch Befehle abgelegt, die beschreiben, welche Operationen mit welchen Werten ausgeführt werden sollen.

Gemäß einer bevorzugten Ausführungsform der vorliegenden Erfindung wird vorgeschlagen, dass die Filterung der Eingangswerte nach Art eines Finite-Impulse-Response (FIR)-Filters erfolgt. Ein FIR-Filter ist bspw. in Tietze, Ullrich: Halbleiter-Schaltungstechnik, a. a. O. S. 807 ff. beschrieben. Alternativ wird vorgeschlagen, dass die Filterung der Eingangswerte nach Art eines Infinite-Impulse-Response (IIR)-Filter erfolgt. Ein IIR-Filter ist bspw. in Tietze, Ullrich: Halbleiter-Schaltungstechnik, a. a. O. S. 833 ff. beschrieben.

Als eine weitere Lösung der Aufgabe der vorliegenden Erfindung wird ausgehend von dem Verfahren zur digitalen Filterung von Eingangswerten der eingangs genannten Art vorgeschlagen, dass die Datenübertragung der Filterkoeffizienten, der Eingangswerte und der Ausgangswerte zwischen der Multiplizierer-Akkumulator-Stufe (MAC) und dem Speicherbereich als ein Direct-Memory-Access (DMA)-Übertragung ausgeführt wird.

Gemäß einer bevorzugten Weiterbildung der vorliegenden Erfindung wird vorgeschlagen, dass die Eingangswerte rekursiv gefiltert werden. Bei einer rekursiven Filterung gehen zusätzlich zu den Eingangswerten auch zurückliegende Ausgangswerte in den neuen aktuellen Ausgangswert ein. Die rekursive Filterung von digitalen Eingangswerten wird ausführlich in Schrüfer, Elmar, Signalverarbeitung: Numerische Verarbeitung digitaler Signale, Carl Hanser Verlag, 1990, Seiten 206-234 beschrieben, auf das hier ausdrücklich Bezug genommen wird.

Gemäß einer bevorzugten Ausführungsform der vorliegenden Erfindung wird vorgeschlagen, dass die Teilprodukte für alle Filterstufen und die Summen der Teilprodukte aller Filterstufen seriell gebildet werden. Zur Berechnung eines Ausgangswertes werden die Eingänge des Multiplizierers der MAC einmal durch alle Filterstufen geschoben und die sich ergebenden Teilprodukte in dem Summierer aufsummiert. Die serielle Realisierung der digitalen Filteranordnung hat den Vorteil, dass lediglich ein Multiplizierer und nur ein Summierer in der MAC benötigt werden, wohingegen bei einer parallelen Realisierung der digitalen Filteranordnung für jede Filterstufe ein eigener Summierer und sogar für alle Filterstufen ein eigener Multiplizierer zuzüglich eines weiteren Mulitplizierers benötigt werden.

### Zeichnungen

Ein bevorzugtes Ausführungsbeispiel der vorliegenden Erfindung wird im folgenden anhand der Zeichnungen näher erläutert. Es zeigen:
- Figur 1: einen Mikroprozessor mit einer erfindungsgemäßen digitalen Filteranordnung;
- Figur 2: eine erfindungsgemäße digitale Filteranordnung gemäß einer bevorzugten Ausführungsform; und
- Figur 3: ein Ablaufdiagramm eines erfindungsgemäßen Verfahrens zur digitalen Filterung gemäß einer bevorzugten Ausführungsform.

### Beschreibung des Ausführungsbeispiels

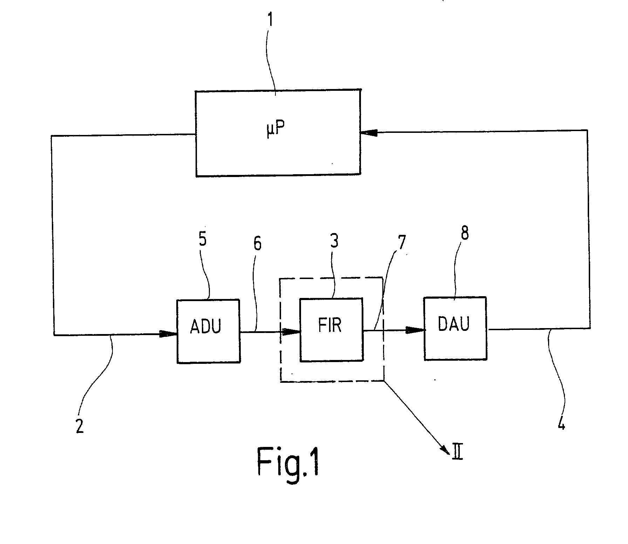

In Figur 1 ist ein Mikroprozessor 1 eines Steuergeräts für ein Kraftfahrzeug dargestellt. Das Steuergerät dient zur Steuerung/Regelung bestimmter Funktionen des Kraftfahrzeugs, bspw. der Brennkraftmaschine, des Getriebes, der Bremsen oder der Heizung/Klimatisierung des Kraftfahrzeuginnenraums. Zur Steuerung/Regelung der Kraftfahrzeugfunktionen verarbeitet der Mikroprozessor 1 Eingangssignale in analoger oder digitaler Form. Zur Steuerung/Regelung bestimmter Kraftfahrzeugfunktionen, bspw. zur Steuerung der Brennkraftmaschine, ist es erforderlich, die Eingangssignale zu filtern.

In neuerer Zeit wird mehr und mehr dazu übergegangen, die Signalverarbeitung nicht analog sondern digital durchzuführen. Die Vorteile liegen in der höheren Genauigkeit und Reproduzierbarkeit sowie in der geringeren Störempfindlichkeit. Nachteilig ist der höhere Schaltungsaufwand, der jedoch angesichts des zunehmenden Integrationsgrades digitaler Schaltungen immer weniger ins Gewicht fällt. Statt kontinuierlicher Größen werden bei der digitalen Signalverarbeitung diskrete Zahlenfolgen verarbeitet. An einem digitalen Filter liegen keine analogen Eingangssignale, sondern diskrete Eingangswerte an und nach der Filterung wird kein analoges Ausgangssignal, sondern eine Folge diskreter Ausgangswerte ausgegeben.

In Figur 1 gibt der Mikroprozessor 1 zu filternde Eingangssignale 2 an ein digitales Filter 3 und empfängt am Ausgang des digitalen Filters 3 das gefilterte Ausgangssignal 4. Vor der eigentlichen digitalen Filterung werden die Eingangssignale durch einen Analog-Digital-Umsetzer (ADU) 5 in diskrete Eingangswerte 6 umgesetzt und gefilterte diskrete Ausgangswerte 7 durch einen Digital-Analog-Umsetzer (DAU) 8 in das analoge Ausgangssignal 4 umgesetzt.

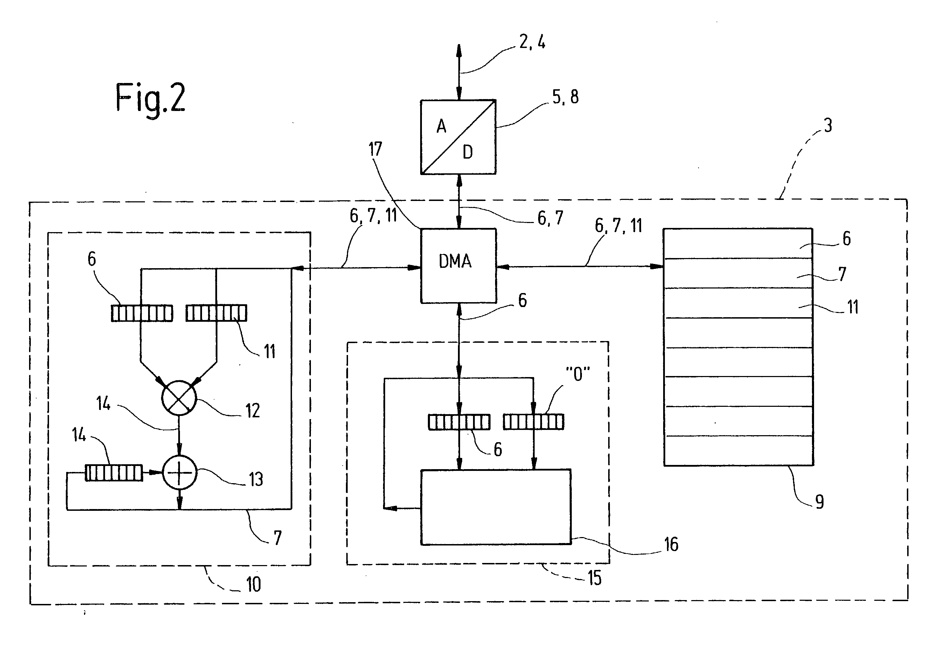

Das erfindungsgemäße digitale Filter 3 ist in Figur 2 vergrößert dargestellt. Das digitale Filter 3 weist mehrere Filterstufen auf. Die Ordnung des digitalen Filters entspricht der Anzahl der Filterstufen. Das digitale Filter 3 weist einen Speicherbereich 9 und eine Multiplizierer-Akkumulator-Stufe (MAC) 10 auf. Der Speicherbereich 9 ist als ein Schreib-Lese-Speicher mit wahlfreiem Zugriff (Random-Access-Memory, RAM) ausgebildet. Die Eingangswerte 6, feste Filterkoeffizienten 11 des digitalen Filters 3 und die gefilterten Ausgangswerte 7 werden in dem Speicherbereich 9 abgelegt und bei Bedarf aus diesem wieder aufgerufen. Die MAC 10 weist einen Multiplizierer 12 und einen Summierer 13 auf. Der Multiplizierer 12 bildet für alle Filterstufen des digitalen Filters 3 Teilprodukte 14 aus den Eingangswerten 6 und den Filterkoeffizienten 11. Der Summierer 13 bildet Summen der Teilprodukte 13 aller Filterstufen als Ausgangswerte 7.

Schließlich weist das digitale Filter 3 Mittel 15 zum Bilden des Betrags der Eingangwerte 6 auf. Die Mittel 15 umfassen einen digitalen Komparator 16, in dem ein Eingangswert 6 mit dem Wert Null verglichen wird, und das Vorzeichen des Eingangswerts 6 umgekehrt wird, falls der Eingangswert 6 kleiner als Null ist. Durch die Mittel 15 zum Bilden des Betrags der Eingangswerte 6 wird erreicht, dass im Rahmen der digitalen Filterung nur mit positiven Werten gerechnet werden muß.

Um den Mikroprozessor 1 durch die digitale Filterung der Eingangssignale nicht zu Belasten, weist das erfindungsgemäße digitale Filter 3 einen Direct-Memory-Access (DMA)-Controller 17 auf. Der DMA-Controller 17 koordiniert die Datenübertragung der Filterkoeffizienten 11 der Eingangswerte 6 und der Ausgangswerte 7 zwischen der MAC 10 und dem Speicherbereich 9. Darüber hinaus koordiniert der DMA-Controller 17 die Datenübertragung der Eingangswerte 6 von dem analogen ADU 5 in den Speicherbereich 9 und der Ausgangswerte 7 von dem Speicherbereich 9 zu dem DAU 8. Schließlich koordiniert der DMA-Controller 17 die Datenübertragung der Eingangswerte 6 von dem Speicherbereich 9 zu den Mitteln 15 und von den Mitteln 15 zu der MAC 10.

Neben den Eingangswerten 6, den Ausgangswerten 7 und den Filterkoeffizienten 11 sind in dem Speicherbereich 9 auch Befehle abgelegt, die beschreiben, welche Operationen mit welchen Werten ausgeführt werden sollen. Diese Befehle werden von dem DMA-Controller 17 abgearbeitet. Der Mikroprozessor 1 muß zur digitalen Filterung eines Eingangswertes 6 lediglich die digitale Filterung anstoßen. Die Datenübertragung und die digitale Filterung wird dann von dem DMA-Controller 17 koordiniert. Der Mikroprozessor übernimmt am Ende der digitalen Filterung lediglich den gefilterten digitalen Ausgangswert 7 von dem digitalen Filter 3 und wandelt diesen in ein analoges Ausgangssignal 4 um.

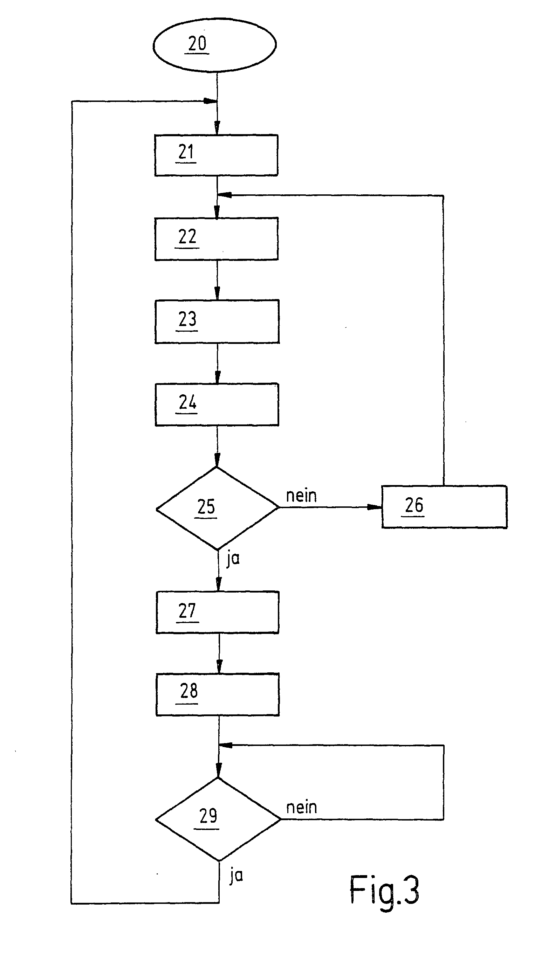

Der Ablauf des erfindungsgemäßen Verfahrens gemäß einer bevorzugten Ausführungsform ist in Figur 3 dargestellt. Das Verfahren beginnt im Funktionsblock 20 mit der Initialisierung des Mikroprozessors 1 und des digitalen Filters 3. In einem Funktionsblock 21 wird ein neuer Eingangswert 6 in den Speicherbereich 9 abgelegt. Anschließend wird in einem Funktionsblock 22 der zu filternde Eingangswert 6 und ein Filterkoeffizient 11 des digitalen Filters 3 über einen DMA-Kanal des DMA-Controllers 17 aus dem Speicherbereich 9 in die MAC 10 übertragen. Im Funktionsblock 22 wird zunächst ein Filterkoeffizient 11 und der zu filternde Eingangswert 6 aus dem Speicherbereich 9 über den DMA-Controller 17 in die MAC 10 übertragen. Im Funktionsblock 23 wird in dem Multiplizierer 12 das Teilprodukt 14 aus dem Eingangswert 6 und dem Filterkoeffizienten 11 gebildet. In einem Funktionsblock 24 wird dann durch den Summierer 13 die Summe aus dem berechneten Teilprodukt 14 und der Summe der Teilprodukte aller vorherigen Filterstufen gebildet. In einem Abfrageblock 25 wird überprüft, ob alle Filterkoeffizienten 11 des digitalen Filters 3 abgearbeitet worden sind. Falls nein, wird dem Funktionsblock 26 der nächste Filterkoeffizient 11 ausgewählt und anschließend zu dem Funktionsblock 20 verzweigt, wo dann der zu filternde Eingangswert 6 und der nächste Filterkoeffizient 11 in die MAC 10 übertragen werden. Diese Schleife, bestehend aus den Funktionsblöcken 22 bis 26 wird solange durchlaufen, bis sämtliche Filterkoeffizienten 11 des digitalen Filters 3 abgearbeitet worden sind, d.h. bis die digitale Filterung des Eingangswertes 6 beendet ist. Die in dem Summierer 13 ermittelte Summe der Teilprodukte 14 bildet dann dann den gefilterten Ausgangswert 7 der digitalen Filterung. Der Ausgangswert 7 wird dann in einem Funktionsblock 27 über den DMA-Controller 17 in dem Speicherbereich 9 abgelegt. In einem Funktionsblock 28 wird wieder der erste Filterkoeffizient 11 des digitalen Filters 3 ausgewählt. In einem Abfrageblock 29 wird solange gewartet, bis ein neuer zu filternder Eingangswert 6 zur Verfügung steht. Sobald ein solcher zu filternder Eingangswert 6 vorliegt, wird das erfindungsgemäße Verfahren für diesen Eingangswert 6 wiederholt.

Vorhergehend ist also eine digitale Filteranordnung und ein Filterverfahren beispielhaft für den erfindungsgemässen Gegenstand gezeigt. Wie bereits in der Einleitung erwähnt ist dies aber allgemein auf eine digitale Signalverarbeitungsanordnung und eine Speicheranordnung mit Signalverarbeitungsstufe übertragbar. Die Erfindung besteht somit allgemein darin ein Speichermodul um die Fähigkeit zu erweitern ohne Prozessorunterstützung die im Speichermodul vorhandenen Daten, insbesondere mittels Multiplizierer und Summierer, verarbeiten zu können. Speziell digitale Filter können damit mit geringer Prozessorbelastung ausgeführt werden. Dies wird erreicht, indem entweder eine digitale Signalverarbeitungsanordnung, insbesondere Filteranordnung, die einen Speicherbereich enthält mit einem DMA-Controller ausgestattet wird oder in eine Speicheranordnung mit einem DMA-Controller eine Signalverarbeitungsstufe integriert wird. Damit wird der Verarbeitungsprozess nur initiiert und kann somit mit sehr geringer Prozessorbelastung ablaufen.

## Patentansprüche

1. Speicheranordnung mit einem Speicherbereich (9) und mit einem Direct-Memory-Access(DMA)-Controller (17) dadurch gekennzeichnet, dass die Speicheranordnung eine Signalverarbeitungsstufe (10) enthält, welche Mittel (12, 13) zur Verarbeitung von Eingangswerten und Koeffizienten zu Ausgagswerten aufweist, wobei die Koeffizienten im Speicherbereich abgelegt sind oder werden und Eingangswerte in den Speicherbereich abgelegt werden und über einen direkten Speicherzugriff mittels des Direct-Memory-Access(DMA)-Controllers die Eingangswerte oder die Eingangswerte und die Koeffizienten aus dem Speicherbereich in die Signalverarbeitungsstufe geladen werden, wobei die Eingangswerte oder die Eingangswerte und die Koeffizienten in der Signalverarbeitungsstufe durch die Mittel zu Ausgangswerten verknüpft werden, wobei die Ausgangswerte zur weiteren Verwendung in den Speicherbereich geschrieben werden.

2. Digitale Signalverarbeitungsanordnung zur digitalen Signalverarbeitung von Eingangswerten (6), mit einem Speicherbereich (9) und mindestens einer Multiplizierer-Akkumulator-Stufe (MAC) (10), die mindestens einen Multiplizierer (12) und mindestens einen Summierer (13) aufweist, wobei die Eingangswerte (6), Koeffizienten (11) und Ausgangswerte (7) der Signalverarbeitungsanordnung in dem Speicher (9) ablegbar und aus diesem bei Bedarf wieder aufrufbar sind und wobei die Eingangswerte (6) mit den Koeffizienten (11) durch den wenigstens einen Multiplizierer und den wenigstens einen Summierer verknüpft werden, wobei der Multiplizierer (12) Produkte (14) aus den Eingangswerten (6) und den Koeffizienten (11) und der Summierer (13) Summen der Produkte (14) als Ausgangswerte (7) der Signalverarbeitungsanordnung bildet, dadurch gekennzeichnet, dass die digitale Signalverarbeitungsanordnung einen Direct-Memory-Access (DMA)-Controller (17) zur Koordinierung der Datenübertragung der Koeffizienten (11), der Eingangswerte (6) und der Ausgangswerte (7) zwischen der Multiplizierer-Akkumulator-Stufe (MAC) (10) und dem Speicherbereich (9) aufweist.

3. Digitale Signalverarbeitungsanordnung mit mehreren Filterstufen zur digitalen Filterung von Eingangswerten (6), mit einem Speicherbereich (9) und mindestens einer Multiplizierer-Akkumulator-Stufe (MAC) (10), die mindestens einen Multiplizierer (12) und mindestens einen Summierer (13) aufweist, wobei die Eingangswerte (6), feste Filterkoeffizienten (11) und Ausgangswerte (7) der Signalverarbeitungsanordnung in dem Speicherbereich (9) ablegbar und aus diesem bei Bedarf wieder aufrufbar sind und wobei der Multiplizierer (12) für alle Filterstufen Teilprodukte (14) aus den Eingangswerten (6) und den Filterkoeffizienten (11) und der Summierer (13) Summen der Teilprodukte (14) aller Filterstufen als Ausgangswerte (7) der Signalverarbeitungsanordnung bildet, dadurch gekennzeichnet, dass die digitale Signalverarbeitungsanordnung einen Direct-Memory-Access (DMA)-Controller (17) zur Koordinierung der Datenübertragung der Filterkoeffizienten (11), der Eingangswerte (6) und der Ausgangswerte (7) zwischen der Multiplizierer-Akkumulator-Stufe (MAC) (10) und dem Speicherbereich (9) aufweist.

4. Digitale Signalverarbeitungsanordnung nach Anspruch 3, dadurch gekennzeichnet, dass die Signalverarbeitungsanordnung einen Analog-Digital-Umsetzer (ADU) (5) und einen Digital-Analog-Umsetzer (DAU) (8) aufweist, wobei der DMA-Controller (17) die Datenübertragung der Eingangswerte (6) von dem ADU (5) in den Speicherbereich (9) und der Ausgangswerte (7) von dem Speicherbereich (9) zu dem DAU (8) koordiniert.

5. Digitale Signalverarbeitungsanordnung nach Anspruch 3 oder 4, dadurch gekennzeichnet, dass die Signalverarbeitungsanordnung Mittel (15) zum Bilden des Betrags der Eingangswerte (6) aufweist, wobei der DMA-Controller (17) die Datenübertragung der Eingangswerte (6) von dem Speicherbereich (9) zu den Mitteln (15) zum Bilden des Betrags und von den Mitteln (15) zu der MAC (10) koordiniert.

6. Digitale Signalverarbeitungsanordnung nach Anspruch 5, dadurch gekennzeichnet, dass die Mittel (15) zum Bilden des Betrags der Eingangswerte (6) einen digitalen Komparator (16) aufweisen.

7. Digitale Signalverarbeitungsanordnung nach einem der Ansprüche 3 bis 6, dadurch gekennzeichnet, dass der Speicherbereich (9) als ein Schreib-Lese-Speicher mit wahlfreiem Zugriff (Random Access Memory, RAM) ausgebildet ist.

8. Digitale Signalverarbeitungsanordnung nach einem der Ansprüche 3 bis 7, dadurch gekennzeichnet, dass die Filterung der Eingangswerte (6) nach Art eines Finite-Impulse-Response (FIR)-Filters erfolgt.

9. Digitale Signalverarbeitungsanordnung nach einem der Ansprüche 3 bis 7, dadurch gekennzeichnet, dass die Filterung der Eingangswerte (6) nach Art eines Infinite-Impulse-Response (IIR)-Filters erfolgt.

10. Verfahren zur Speicherung von Werten in einer Speicheranordnung mit einem Speicherbereich (9) und mit einem Direct-Memory-Access (DMA) -Controller (17) dadurch gekennzeichnet, dass die Werte in der Speicheranordnung durch eine darin enthaltene Signalverarbeitungsstufe (10) verarbeitet werden, welche Mittel (12, 13) zur Verarbeitung von Eingangswerten und Koeffizienten zu Ausgagswerten aufweist, wobei die Koeffizienten im Speicherbereich abgelegt sind oder werden und Eingangswerte in den Speicherbereich abgelegt werden und über einen direkten Speicherzugriff mittels des Direct-Memory-Access(DMA)-Controllers die Eingangswerte oder die Eingangswerte und die Koeffizienten aus dem Speicherbereich in die Signalverarbeitungsstufe geladen werden, wobei die Eingangswerte oder die Eingangswerte und die Koeffizienten in der Signalverarbeitungsstufe durch die Mittel zu Ausgangswerten verknüpft werden, wobei die Ausgangswerte zur weiteren Verwendung in den Speicherbereich geschrieben werden.

11. Verfahren zur digitalen Signalverarbeitung von Eingangswerten (6),in einer Signalverarbeitungsanordnung mit einem Speicherbereich (9) und mindestens einer Multiplizierer-Akkumulator-Stufe (MAC) (10), die mindestens einen Multiplizierer (12) und mindestens einen Summierer (13) aufweist, wobei die Eingangswerte (6), Koeffizienten (11) und Ausgangswerte (7) der Signalverarbeitungsanordnung in dem Speicher (9) ablegbar und aus diesem bei Bedarf wieder aufrufbar sind und wobei die Eingangswerte (6) mit den Koeffizienten (11) durch den wenigstens einen Multiplizierer und den wenigstens einen Summierer verknüpft werden, wobei der Multiplizierer (12) Produkte (14) aus den Eingangswerten (6) und den Koeffizienten (11) und der Summierer (13) Summen der Produkte (14) als Ausgangswerte (7) der Signalverarbeitungsanordnung bildet, dadurch gekennzeichnet, dass die digitale Signalverarbeitungsanordnung einen Direct-Memory-Access (DMA)-Controller (17) aufweist, der die Datenübertragung der Koeffizienten (11), der Eingangswerte (6) und der Ausgangswerte (7) zwischen der Multiplizierer-Akkumulator-Stufe (MAC) (10) und dem Speicherbereich (9) koordiniert.

12. Verfahren zur digitalen Signalverarbeitung, insbesondere Filterung, von Eingangswerten (6) in einer digitalen Signalverarbeitungsanordnung, wobei die Eingangswerte (6), feste Filterkoeffizienten (11) und Ausgangswerte (7) der Signalverarbeitungsanordnung in einem Speicherbereich (9) der Signalverarbeitungsanordnung abgelegt und bei Bedarf aus diesem wieder aufgerufen werden und wobei in einer Multiplizierer-Akkumulator-Stufe (MAC) (10) der Signalverarbeitungsanordnung für alle Filterstufen Teilprodukte (14) aus den Eingangswerten (6) und den Filterkoeffizienten (11) und Summen der Teilprodukte (14) aller Filterstufen als Ausgangswerte (7) der Signalverarbeitungsanordnung gebildet werden, dadurch gekennzeichnet, dass die Datenübertragung der Filterkoeffizienten (11), der Eingangswerte (6) und der Ausgangswerte (7) zwischen der Multiplizierer-Akkumulator-Stufe (MAC) (10) und dem Speicherbereich (9) als eine Direct-Memory-Access (DMA)-Übertragung ausgeführt wird.

13. Verfahren nach Anspruch 12, dadurch gekennzeichnet, dass die Eingangswerte (6) rekursiv gefiltert werden.

14. Verfahren nach Anspruch 12 oder 13, dadurch gekennzeichnet, dass die Teilprodukte (14) für alle Filterstufen und die Summen der Teilprodukte (14) aller Filterstufen seriell gebildet werden.
